Europäisches Patentamt

(19) European Patent Office

Office européen des brevets

(11) EP 0 926 812 A1

(12) EUROPEAN PATENT APPLICATION

(43) Date of publication:
30.06.1999 Bulletin 1999/26

(51) Int. Cl.⁶: **H03D 9/04**, H04L 27/38

(21) Application number: 97122438.1

(22) Date of filing: 18.12.1997

(84) Designated Contracting States:
AT BE CH DE DK ES FI FR GB GR IE IT LI LU MC
NL PT SE
Designated Extension States:
AL LT LV MK RO SI

(71) Applicant:
Sony International (Europe) GmbH
50829 Köln (DE)

(72) Inventors:
• Brankovic, Veselin, Dr.
  Stuttgarter Strasse 406, 70736 Fellbach (DE)
• Krupezevic, Dragan, Dr.
  Stuttgarter Strasse 406, 70736 Fellbach (DE)

(74) Representative:
Rupp, Christian Dipl.Phys. et al
Mitscherlich & Partner
Patent- und Rechtsanwälte
Sonnenstrasse 33
80331 München (DE)

(54) **Six-port junction device**

(57)     According to the present invention a 6-port junction device usable as a direct conversion 6-port receiver is proposed. The receiver according to the present invention comprises two passive 4-port means (1, 2), which can be resistive networks for example, and which are connected with each other by a phase shifting element 3. Each of the passive 4-port means (1, 2) comprises a port (4) for the input of respectively one RF-signal as well as two output ports for providing output signals being linear combinations of the RF-input signals. Power sensors $P_1$ to $P_4$ are provided to detect the respective power levels of the output signals. According to the present invention discrete solutions based on resistor technology as well as distributed microstrip technology are presented. Due to the application of resistors it is possible to achieve a large frequency band of operation. The proposed device can be realized by monolithic microwave integrated circuit-technology.

Fig. 1

EP 0 926 812 A1

## Description

The present invention relates to a 6-port junction device for the processing of RF-signals, and a method for the direct down conversion of RF-signals. The principle of the present invention finds its application for example in the reception of RF signals or the vector measurement of RF signals based on a six-port junction device.

The 6-port technology which has been used up to the last years for complex measurements can also be utilized for the reception and detection of RF-signals. A 6-port receiver acts in the direct conversion manner allowing conversion from mm-wave range and microwave range directly to the base band. At the same time a classic I/Q-demodulation chip (digital or analog) can be avoided. By using suitable calibration procedures the influences of the non-ideal passive RF-components including manufacturing tolerances can be minimized. The 6-port receiver detects the relative phase and relative magnitude of two incoming RF-signals. The circuitry of the 6-port receiver is realized using only passive components in combination with diodes for the detection of the relative phase and the relative magnitude of the RF-signals. An important feature of 6-port receivers is that fabrication tolerances can be calibrated, which inherently allows low-cost production.

In Bossisio, Wu "A 6-port direct digital millimeter wave receiver", Digest of 1994 IEEE MTT Symposium, vol. 3, page 1659 - 1662, San Diego, May 1994, a structure for a 6-port receiver is proposed.

The 6-port technique has been known for its ability to accurately measure the scattering parameters, both amplitude and phase, of microwave networks. Instead of using heterodyne receivers a 6-port receiver accomplishes direct measurements at microwave and mm-wave frequencies by extracting power levels at at least three and particularly four of the 6 ports. The imperfections of the hardware can be readily eliminated by an appropriate calibration procedure. Very accurate measurements can be made in a large dynamic range and wide frequency range. 6-port junction receivers consist of passive microwave components such as directional couplers and power dividers as well as diode detectors. The circuit can be easily integrated as MHMIC or MMIC. The known receiver performs direct phase/amplitude demodulation at microwave and mm-wave frequencies.

By performing a calibration procedure the hardware imperfections such as phase error of the bridges, imbalance of the power detectors, etc. can be readily eliminated. This significantly eases the requirement of the hardware implementation and enables the 6-port receiver to operate over a wide band up to mm-wave frequencies.

According to the above cited document of Bossisio et. al. a 6-port receiver concept with power dividers and 90 degrees hybrid circuits realized in distributed technology is used. The application of that known structure lies mainly in the frequency bands above 10 GHz, however, it suffers from an insufficient band width of the operation due to the inherently frequency selective nature of the 90 degrees hybrid circuits.

From D. Maurin, Y.Xu, B.Huyart, K.Wu, M. Cuhaci, R. Bossisio "CPW Millimeter-Wave Six-Port Reflectometers Using MHMIC and MMIC technologies", European Microwave Conference 1994, pp. 911-915, a wide-band topology for reflectometer used is known which is based on a distributing element approach featuring coplanar wave guide applications in the frequency range from 11 to 25 GHz.

From V. Bilik, et al. "A new extremely wideband lumped six-port reflectometer" European Microwave Conference 1991, pp. 1473-1477 and the idea of using Wheatstone Bridges and resistive structures for reflectometer applications is known.

From j:Li, G.Bossisio, K.Wu, "Dual tone Calibration of Six-Port Junction and its application to the six-port direct digital receiver", IEEE Transactions on Microwave Theory and Techniques, vol. 40, January 1996 a six-port reflectometer topology based on four 3dB hybrid circuits, power dividers and attenuators is known.

From US-A-5498969 an asymmetrical topology for a reflectometer structure featuring matched detectors and one unmatched detector is known.

From US-A-4521728 with the title "Method and six-port network for use in determining complex reflection coefficients of microwave networks" a reflectometer 6-port topology is known comprising two different quadrate hybrids, phase shifter, two power dividers and one directional coupler for which the realization by a microstrip line technology is disclosed.

Therefore it is the object of the present invention to provide a 6-port circuitry which allows the processing, particularly detecting, of a large band width of RE-signals and which can be realized with low costs.

It is a further object of the present invention to provide a universal topology of a 6-port circuitry which:

- can be realized using a microwave monolithic integrated circuit technology, and which therefore allows the mass production of a small and low cost chip,

- which can be realized by the MMIC-technology process with lower requirements for fabrication tolerances (meaning a low cost MMIC-process), and

- which is operable in a very large frequency range, e.g. from a predetermined frequency to ten times the predetermined frequency, wherein the same 6-port circuitry (chip) can be used for different communication systems or for ultra wide band software radio communication systems.

The object is achieved by the features of the independent claims. Therefore a new topology for a 6-port receiver is proposed, which can advantageously be used for the direct down conversion and demodulation of RF-signals. One aspect of the present invention is the so-called symmetric approach, i.e. the symmetric structure of the topology. Discrete solutions based on resistors and distributed technology are presented. Due to the application of resistors it is possible to achieve a large frequency band of operation. The proposed topology can be realized by monolithic microwave integrated circuit-technology.

According to the present invention therefore a 6-port junction device for the processing of RF-signals is provided. The device comprises two passive 4-port means being connected with each other by a phase shifting element. Each passive 4-port means thereby comprises a port for the input of respectively one RF-signal in two output ports for providing two output signals being linear combinations of the RF-input signals. Furthermore, power sensors are provided to detect the respective power levels of the output signals.

Thereby the two passive 4-port means can be identical and can furthermore be connected with each other symmetrically.

Respectively one power sensor can be connected to one of said output ports and a signal processing unit can be provided to calculate complex ratio of the two input RF-signals on the basis of the power level values detected by the power sensors.

The power sensors can respectively comprise at least one detector diode.

The power sensors can furthermore comprise a matching circuitry realized by discrete or distributed elements, a diode memory block storing diode calibration coefficients, a biasing means and/or a processing unit for correcting temperature and non-linear detection errors.

The passive 4-port means respectively can comprise a resistive network.

Thereby the 4-port means can comprise microstrip rings.

The 4-port means can comprise a circular microstrip patch.

The phase shifting element can be a single transmission line, particularly a microstrip line.

The phase shifting element can comprise plurality of coplanar transmission lines.

The phase shifting element can comprise a coplanar wave guide.

The phase shifting element can comprise at least one LC-circuit.

The phase shifting element can comprise a PI-circuitry built up from a plurality of capacitors and an inductivity.

The phase shifting element can comprise a T-LC-circuitry.

The passive 4-port means can comprise a passive power divider and a passive 3-port means, wherein the passive power divider can be connected with said input port for an RF-signal, with a power sensor and with a passive 3-port means. The passive 3-port means furthermore can be connected with another power sensor and with respectively the other 4-port means by means of said phase shifting element.

The passive power divider can comprise at least three resistive elements.

The power divider can be realized by a distributed technology.

The power divider particularly can be realized by a microstrip ring or a circular microstrip patch.

The passive 3-port means can be realized by a distributed technology.

The passive 3-port means can comprise a microstrip line, coplanar strips or a coplanar wave guide.

One of the input RF-signals can be provided by a local oscillator (LO) circuitry.

The LO-circuitry can comprise a power control device for tracking the RF input signal.

The above six-port junction device can be realized by MMIC (monolithic microwave integrated circuit)-technology.

The present invention furthermore relates to the use of a 6-port junction device as explained above for the direct down conversion of a (modulated) RF-signal, the 6-port junction device thereby acting as a I/Q-Demodulator.

The present invention furthermore relates to the use of a 6-port junction device for the direct down conversion of a (n)PSK, (n)QAM or OFDM-modulated RF-signal.

The present invention furthermore relates to a method for the direct down conversion of (modulated) RE-signals. Thereby, respectively one RF-signal is input to one of two passive 4-port means, which two passive 4-port means are connected with each other by a phase shifting element. Respectively two signals are output of each of the passive 4-port means, said output signals being based on linear combinations of said two RF-input signals. The power levels of the four output signals are detected.

One of the input RF-signals can be provided by a local oscillator (LO) circuitry.

The local oscillator circuitry can provide for a power control function.

The power level of the signal provided by the local oscillator circuitry can be set such as to meet the expected power level of the respectively other input RF-signal in the following lime sample.

The power level of the signal provided by the local oscillator circuitry of the time sample (n + 1) can be set on the power level value of the respectively other RF-input signal of the time sample n.

The power level of the signal provided by the local oscillator circuitry can be set on the average power level of the other RF-input signal, wherein the averaging process can be effected on-line.

The present invention furthermore provides for a method for adjusting the power level of a RF signal supplied from a local oscillator circuitry to a six-port receiver, particularly to improve the characteristics of the device as set forth above.

Further characteristics, features and advantages of the present invention will become evident from the following purely illustrative and non-limiting description of embodiments of the present invention taken in conjunction with the figures of the accompanying drawings.

Fig. 1 shows the general concept of the present invention,

Fig. 2 shows an embodiment of the general structures shown in Fig. 1, wherein resistive networks are provided,

Fig. 3 shows an embodiment of the present invention, wherein the two 4-port means are realized as microstrip rings and the phase shifter is realized as a transmission line,

Fig. 4 shows an embodiment of the present invention, wherein the two 4-port means are realized as circular microstrip patches,

Fig. 5 shows an embodiment of the present invention, wherein the 4-port means are build up respectively from a passive 3-port means and a passive power divider,

Fig. 6 shows a possible realization of the 4-port means by a resistive network,

Fig. 7 shows another possible realization of the 4-port means by resistive networks,

Fig. 8 shows a possible realization of the 3-port means and the power divider according to Fig. 5 by resistive networks,

Fig. 9A to 9B show power dividers realized by distributed technology with microstrip rings and microstrip patches, respectively,

Fig. 9C shows a realization of the 3-port means of Fig. 5 with distributed technology,

Fig. 10A to 10C show different realization forms of the phase shifting element according to different embodiments, the phase shifting element being implemented by discrete technology,

Fig. 11 shows the internal structure of a power sensor according to an embodiment,

Fig. 12A to 12C show different realizations of the phase shifting element in distributed technology,

Fig. 13 shows the internal structure of a local oscillator circuitry according to an embodiment,

Fig. 14 shows simulation results of the detection of QPSK states when detected by an inventive 6-port junction device,

Fig. 15 shows simulation results of the detection of 16 QAM states when detected by the inventive 6-port junction device,

Fig. 16 shows the real and imaginary part of the OFDM-symbol detection in the case of ± 5% resistance tolerances in comparison to the ideal symbol outlook,

Fig. 17 shows the relative magnitude (dB) between ideal signals and detected signals in the case of ± 5% resistor tolerances (upper diagram) and relative phase differences (degrees) (lower diagram),

Fig. 18 shows the real and imaginary part of the OFDM-symbol detection in the case of ± 20% resistance tolerances in comparison to the ideal symbol outlook, and

Fig. 19 shows the relative magnitude (dB) between ideal signals and detected signals in the case of ± 20% resistor tolerances (upper diagram) and relative phase differences in degrees (lower diagram),

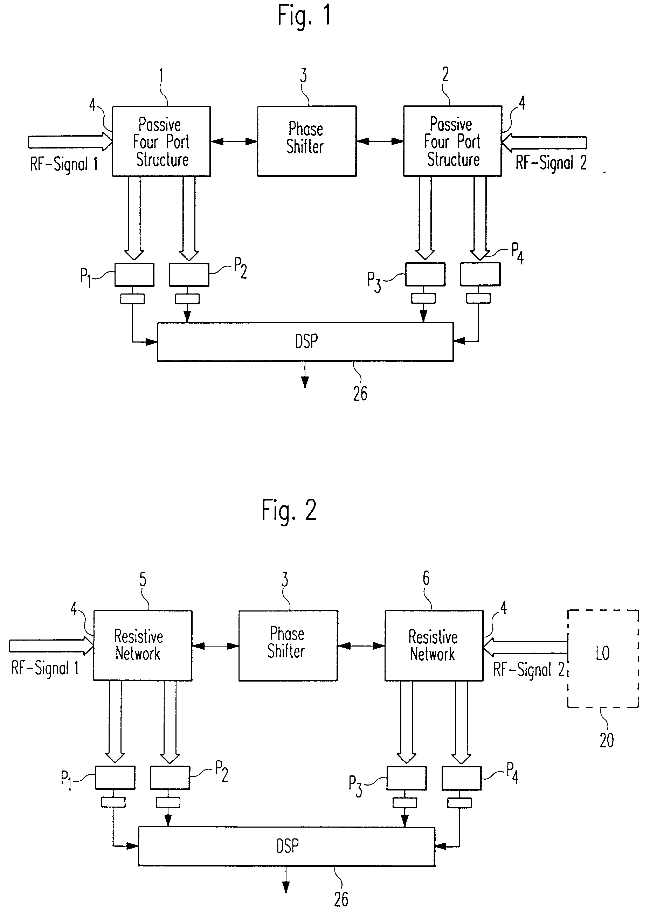

According to the present invention a new topology for a 6-port circuitry usable preferably, but not only, for 6-port receivers is proposed. The basic concept of the proposed 6-port topology is shown in Fig. 1. As shown in Fig. 1 the basic structure of the present invention comprises two passive 4-ports 1, 2 and one phase shifter 3. Respectively one RF-signal is input (reference4) to one of the two passive 4-port structures 1, 2. The two passive 4-port structures 1, 2 are connected with each other by the phase shifter 3. Each of the passive 4-port means 1, 2 comprises two output ports which are connected to power sensors $P_1$ to $P_4$. When the topology according to the present invention is used as a receiver, all of the power sensors (usually comprising detector diodes) are matched, for example on an impedance of 50 Ohm

As it is known from the state of the art, the passive 4-port structures 1, 2 output signals which are representing linear combinations of the input (and eventually phase shifted) RF-signals. The power sensors $P_1$ to $P_4$ detect the power level of the output signals of the passive 4-port means 1, 2. The detected power levels of the output signals are supplied to a digital signal processing unit 26.

Usually plural elements are connected between each power sensor and the DSP 26, which , however, are not shown in the drawings. These elements can comprise a low pass filter, a DC-amplifier and an AD-converter in this order.

It s to be noted that the DSP 26 can be avoided when using simple modulations techniques. In this case analog elements can be provided acting as a decision circuitry do detect the modulation states.

The digital signal processing unit 26 calculates the complex ratio of the two input RF-signals by means of a mathematical treatment of the power level value detected by the power sensors $P_1$ to $P_4$ and can furthermore optionally provide for a demodulation. To summarize, according to the basic concept one of the ports of a passive 4-port means 1, 2 is used to input an RF-signal, one is used to be connected to a phase shifter being connected respectively with another (identical) passive 4-port means 1, 2, and the other two ports are used to output signals to power sensors $P_1$ to $P_4$. The two 4-port means are preferably connected symmetrically to each other.

In order to increase the (frequency) range of operation, the passive 4-port means 1, 2 can be realized by resistive networks using discrete elements 5, 6 as it is shown in the embodiment according to Fig. 2. As it is furthermore shown in Fig. 2 and explained in detail further below, one of the RF-signals input to a passive 4-port means (resistive network) can be provided by a local oscillator circuitry 20.

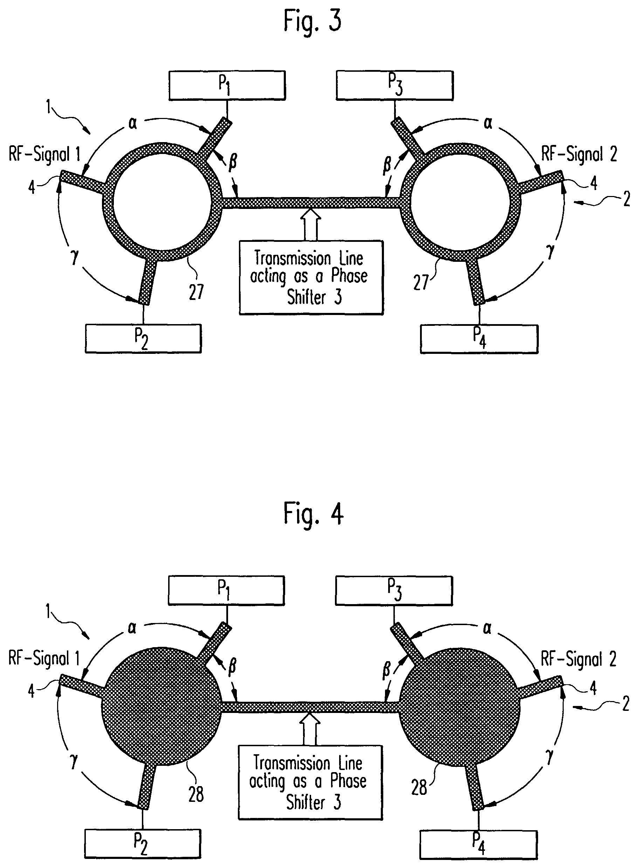

As it is shown in Fig. 3 and 4, the 4-port means 1, 2 resp. resistive networks 7, 8 (Fig. 2) can be realized by using distributed technology. The two examples of Fig. 3 and Fig. 4 show possible topologies, wherein symmetrical structures are used. In both examples a transmission line (e.g. a microstrip line) is used as phase shifting element 3. The passive 4-port means can be realized as shown in Fig. 3 as a microstrip ring 27 or as a circular microstrip patch 28 as shown in Fig. 4.

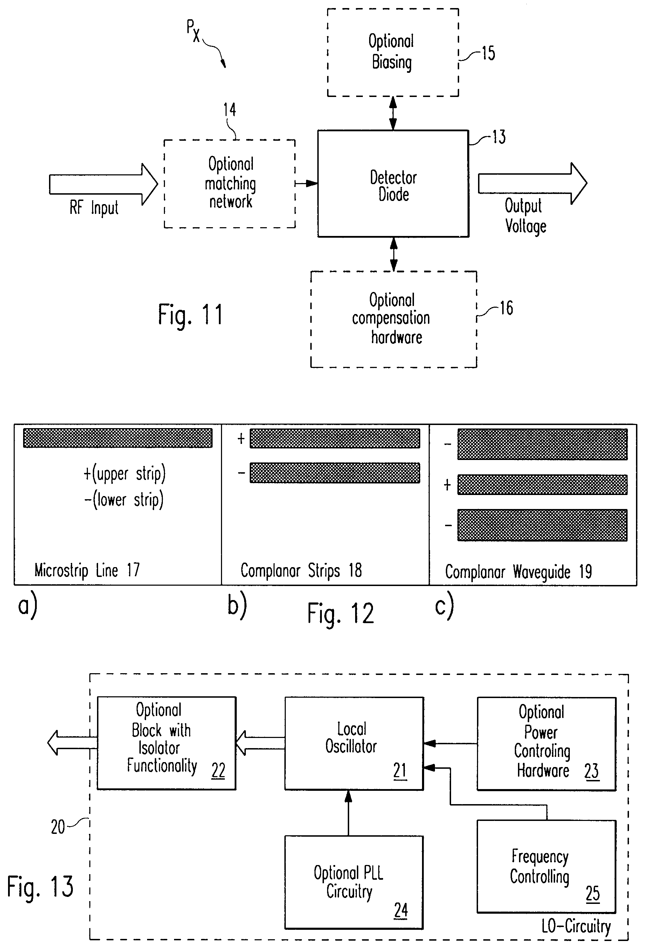

In both cases the diameter (also the inside diameter in the case of Fig. 3) is selected depending on the center frequency of the application. Furthermore, it is to be noted that the strip width along the ring can vary. The angles $\alpha$, $\beta$ and $\gamma$ between respectively two ports are chosen such as to establish the wanted combining ratio of the input RF-signal directly attached to one port of the 4-port means and a signal coming via the transmission line acting as phase shifting element 3. With other words, the angles are set depending on the linear combination of the input RF-signals. For special applications it is also possible to set the values of the angles $\alpha$, $\beta$ and $\gamma$ such as to establish the state that the power sensor $P_2$ (e.g.) detects only the RF-signal 1 meaning that the power sensor $P_2$ and the phase shifting element 3 connected are isolated. At the same time the power sensor $P_1$ can receive and detect the power level as a combined value of the RF-signal and the RF-signal 2 approaching the port of the power sensor $P_1$ via the phase shifting element 3. It is to be noted that the phase shifting element 3 can be realized in distributed technology, e.g. by a plurality of transmission lines as will be explained with reference to Fig. 11 further below.

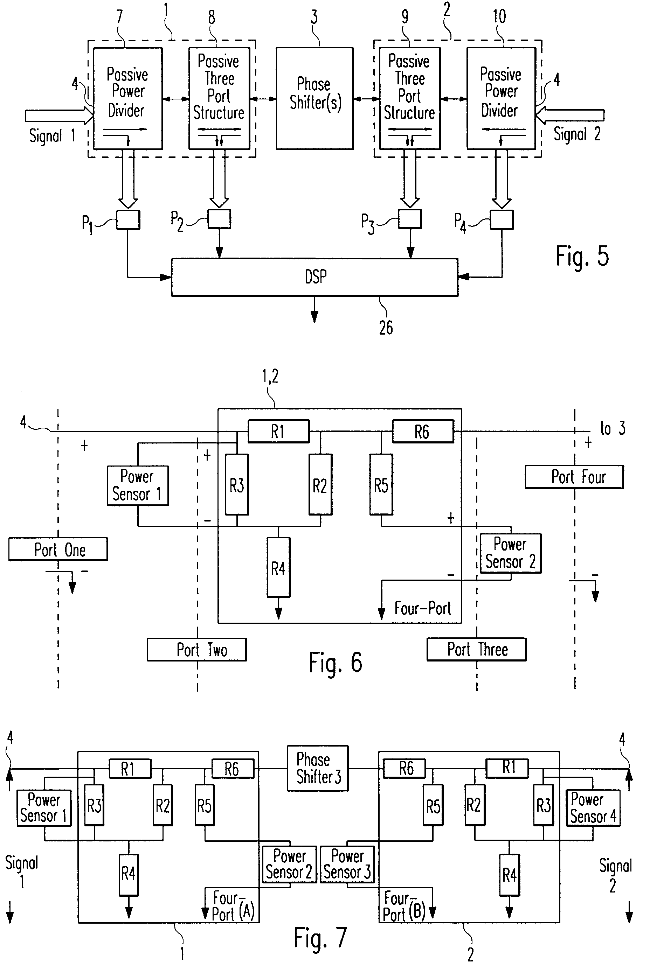

Fig. 6 shows a possible realization of the 4-port means 1, 2 according to Fig. 1 by resistive elements. The whole 4-port means is realized by at least four resistive elements $R_1$ to $R_6$ which are connected as shown in Fig. 6. In the embodiment of Fig. 6 the elements are chosen such that the power sensor $P_1$ only detects the RF-signal coming from port 1 (4), meaning that port 2 and port 4 of Fig. 6 are preferably isolated. Port 3 as shown is finished by the power sensor $P_2$ which detects the combined RF-signals coming from port 1 and port 4. In the following table 1 possible preferable values for the resistors of Fig. 6 are given for three different cases normalized to input characteristic impedance to be seen from port 1 towards outside (usually 50 Ohms or 75 Ohms). It is to be noted that the case is considered that the power sensors have all the same input impedance (matched).

Furthermore it is to noted that the power sensor $P_1$ is connected in parallel to the resistor R3 and the power sensor $P_2$ is connected in series between the resistor R5 and ground, which is a preferable implementation.

In some cases the Resistors R4 and R5 can be neglected. However, the triangularly connected Resistors R1, R2 and R3 are important.

Table 1

| | Z1 | Z2 | Z3 | Z4 | R5 | R6 | R1 | R2 | R3 | R4 |
|---|---|---|---|---|---|---|---|---|---|---|
| Case 1 | ¾ | 1 | 4/3 | 1/3 | 1/3 | 1/3 | 4/3 | 16/9 | 4 | 4/3 |
| Case 2 | 1/2 | 1 | 2 | 1/3 | 1/3 | 1/3 | 1 | 2 | 3 | 2 |
| Case 3 | 1 | $4/\sqrt{5}$ | $4/\sqrt{5}$ | 1/3 | 1/3 | 1/3 | $(\sqrt{5}+1)/3$ | $4/3(1+1/\sqrt{5})$ | $(\sqrt{5}+1)$ | $4/\sqrt{5}$ |

The shown values of the restive elements are particularly advantageous for practical realizations.

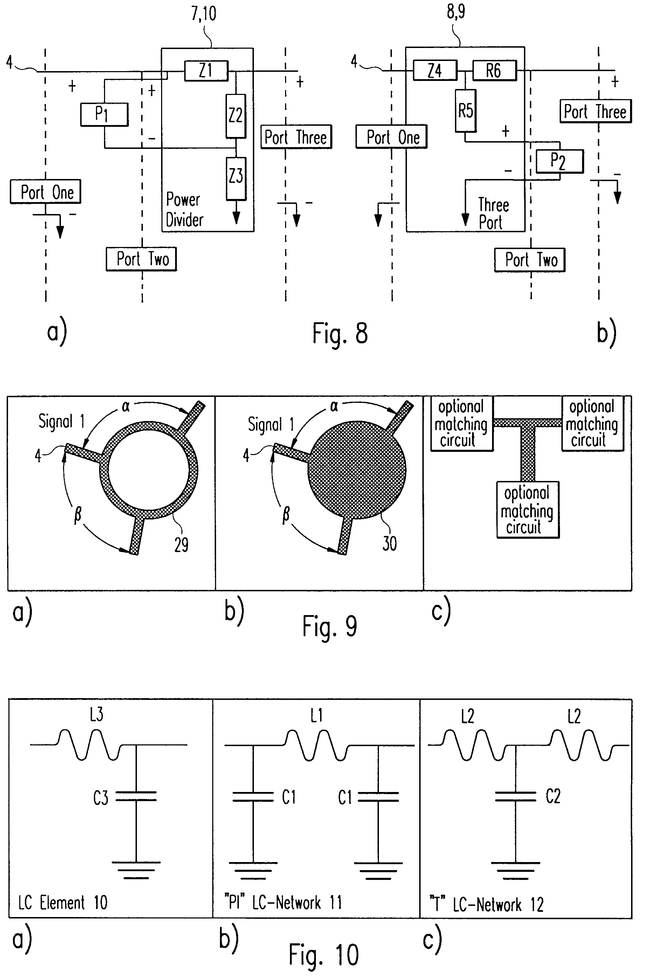

Fig. 7 shows a 6-port junction device (6-port receiver) comprising two 4-port means according to Fig. 5 which are connected symmetrically.

Fig. 5 shows an embodiment of the present invention, wherein each of the 4-port means 1, 2 comprises a passive power divider 7 and a passive 3-port means 8. The passive power divider 7 essentially has the structure of a 3-port means. The passive 3-port means 8 acts as a signal combining means. The power divider 7 has the function to split the power of an input RF-signal in two directions:

a) Towards the input of the 3-port means 8 acting as a power combiner, and

b) towards the input of the power sensor $P_1$.

The port attached to the power sensor is isolated from the port attached to the 3-port means, meaning that only the RF-signal coming from the 3-port means 8 approaches the power sensor $P_1$. This specific realization is achieved when the resistive elements of fig. 8 satisfy the equation: $Z1 * Z2 = (Z2)^2$ .

The passive 3-port means 8, 9 combines the signals coming from the passive power divider 7, 10 and the RF-signals coming from the phase shifter 3, so that combined signals can be detected at the power sensors $P_2$ and $P_3$.

Fig. 8A and 8B show a realization of the power divider 7, 10 and the passive 3-port means 8, 9 of Fig. 5 by resistive elements. As can be seen from Fig. 8A and 8B the passive power divider 7, 10 can be realized by at least 3 resistive elements $Z_1$, $Z_2$ and $Z_3$. The same is true for the passive 3-port means 8 realized by resistive elements $Z_4$, $R_5$ and $R_6$. The possible values (three different cases to be explained later) for the resistive elements are given in the above table 1 normalized to the characteristic impedance of the system (usually 50 Ohms or 75 Ohms). The power sensors $P_1$ to $P_4$ are connected as shown in Fig. 8A and 8B.

Thereby it is to be noted that the power sensor $P_1$ is connected in parallel to the resistors Z1 and Z2 and the power sensor P2 is connected in series between the resistor R5 and ground.

In Fig. 9A to 9C possible distributed element realizations in microstrip technology are shown. Fig. 8A thereby shows the realization of passive power dividers 7, 10 with a microstrip ring 25. Fig. 8B shows the realization of the passive power divider 7, 10 with a microstrip edge 30 and Fig. 8C shows the realization of the passive 3-port means 8, 9 by a microstrip technology with an optional matching circuit.

The angles $\alpha$ and $\beta$ of the microstrip ring and the microstrip circular patch are chosen in a way to ensure an isolation of the ports attached to the power sensor $P_1$ and the passive 3-port means 8, 9. It is to be noted that the diameter and the angles of the rings and the patches are chosen depending on the specific frequency of interest, and furthermore the strip width along the ring can vary. Also in the microstrip realization of Fig. 8C of the 3-port means different strip widths can be used.

In the above table 1 three sets of the values for the resistive elements are proposed taking into account the structures as shown in Fig. 6, 7 and 8. Cases 1 and 2 are leading to the resistive values easy to be realized taking into account the fact that normalization impedance is usually 50 Ohms (sometimes 75 Ohms). These values ensure theoretically the ideal realization of the proposed topology in the case of an ideal input impedance (ideal matching or ideal in search loss) of the power sensors and circuitry providing the RF-signal 1 and the RF-signal 2 in Fig. 1. Taking into account the ideal matching conditions of the power sensors $P_1$ to $P_4$ and the attached circuitry it follows:

Case 1 obtained when the maximum power level which can be detected on the power sensor $P_2$ of Fig. 6 or Fig. 7 is equal to the power level obtained at the power sensor $P_1$ on the same figures, when both RF-signals have the same power level. This will incorporate automatic treatment of the non-linearity case, when the RF-signal approach some predefined border.

Case 2 is evaluated as an ideal case where the signal magnitude approaching power sensor one is the same as average signal magnitude approaching the power sensor two in the case of arbitrary phase shift between the signal one and signal two of the Fig. 1, when they have the same input power level. The case 2 gives very simple easy to be realized and combined resistive ratios. For example if a characteristic impedance is 50 ohm, the whole passive structure can be realized by resistors taking values of: 50 ohm, 100 ohm, 50/3 Ohm, which can be also realized by putting 50 ohm resistor in parallel or serial connections.

Case 3 is obtained considering the fact that middle power to be achieved at the power sensor two is the same as a power detected at the power sensor one, when signals one and two of the Fig. 1 have the same power level and different phases. This approach leads to resistor values not having "the simple" to be realized resistive values, but they make an optimum power leveling.

The following table 2 shows the minimum, maximum and average value of the power level approaching matched power sensors related to the RF-signal power level when the reference level of the opposite port (the second input port for RF-signals 2) has the same power level as the RF-level approaching the first input port (the first input port for RF-signal 1 according to Fig. 1).

It is to be noted that in case matched detector diodes are used, the final resulting power level at the detector diodes can be lower, e.g. 4dB.

Table 2

| | Detected Power Level related to the Input RF Signal (Signal No. one) measured at power sensor No. 1 from Fig. 5, Fig. 6 and Fig. 7 (de-coupled from the Signal No. 2) | Minimum Value of the Detected Power Level related to the Input RF Signal, measured at power sensor No. 2 of the Fig. 6 and Fig. 7. | Maximum Value of the Detected Power level related to the Input RF Signal, measured at power sensor No. 2 of the Fig. 6 and Fig. 7. |
|---|---|---|---|
| Case 1 | -7.36 | -16.9 | -7.36 |
| Case 2 | -9.54 | -15.56 | -6.02 |
| Case 3 | -8.91 | -15-9 | -6.36 |

As can be seen from table 2 the lowest power to be detected in the case of equal power levels of the RF-signals 1 and 2 of Fig. 1 does not exceed the value of 17 dB under the input RF-level for the case 1 and 16 dB under the input RF-level for case 2 and case 3. According to these values and the lowest power sensing threshold of the power sensors the minimum input RF-level which should be present at the 6-port junction device according to the present invention can be calculated. That means that the required LNA amplification can also be determined. It is to be noted that in general 6-port receivers require more LNA amplification gain as a conventional receiver, but at the same time the required LO-level is ideally at the same level as the RF-signal approaching the other 6-port input. That means that instead of for example 10 dB LO (local oscillator) power usually required for a conventional (heterodyne) receiver, in the case of the coherent direct 6-port receiver embodying the present invention typically only around -20 to -10 dB are required.

If a resistive, mainly discrete approach is used for the 4-port means (or the power divider in the 3-port means), there are two options to realize the phase shifting element 3:

a) Using a distributed technology as shown in Fig. 12, where the phase shifting element 3 is realized by transmission lines 17, 18, which do not have to be straight (they can also be made in a curve-like shape in order to minimize the length of the line) and

b) by using discrete LC-elements as shown in Fig. 10.

In Fig. 10A to 10C three different cases are shown. As shown in Fig. 10A the phase shifting element can be realized by at least one inductivity $L_3$ and one capacitor $C_3$ making up one LC-cell 10.

As shown in Fig. 10B the phase shifting element can be realized by a "PI" LC-network 11 comprising two capacitors $C_1$ and one inductivity $L_1$.

As shown in Fig. 10C the phase shifting element can be realized by a T-LC-network 12 comprising two inductivities $L_1$, $L_2$ and one capacitor $C_2$ connected in a T-shape. In Fig. 11 the internal structure of a power sensor $P_x$ ($0 < x < 5$; x being an integer) is shown. A power sensor $P_x$ essentially comprises at least one detector diode 13, an optional matching network 14, an optional biasing element 15, and an optional compensation hardware 16 providing for a temperature compensation of the diode characteristic. The optional matching network 14 is preferably realized by frequency independent elements (preferably using resistive elements) and is responsible to transform the power sensor input impedance to the same value as the characteristic impedance of the system (usually 50 Ohms or 75 Ohms). The biasing elements 15 give the possibility to increase the sensitivity of the detector diode 13 when applied according to the technology of the used diode process, and external system requirements. The optional compensation hardware 16 can automatically modify the information of the detected power (usually D/C-voltage) in order to minimize the temperature influences or diode non-linearity if a detected signal exceeds a previously assigned voltage border. Of course this function can also be achieved by software corrections for using the measured power values for the calculation of the complex ratio of the two input RF-signals in the digital signal processing unit 26.

Fig. 11 shows possible realizations of the phase shifting element in distributed technology. According to Fig. 12A the phase shifting element can be realized by a microstrip line 17. As shown in Fig. 12B the phase shifting element can be realized by coplanar strips 18. As shown in Fig. 12C the phase shifting element 3 alternatively can be realized as a coplanar wave guide 19.

If the 6-port junction device according to the present invention is to be used as a 6-port direct receiver usually one of the ports where the RF-signals are fed into the circuitry (see Fig. 1) is fed by a local oscillator (LO) circuitry as reference with 20 in Fig. 13. The LO-circuitry 20 comprises a local oscillator 21 and optionally a power controlling hardware block 23, a PLL block 24, a frequency controlling block 25 and a block 22 having an isolator function as shown in Fig. 13.

The detection quality of the signal is a very important issue when using the present 6-port junction device or generally when using 6-port receivers. This quality can be defined as the insensitivity of the detection regarding non-ideal RF-subparts used in the device. In the simulations as shown further on, the sensitivity of the system and the detection quality are influenced by the power ratio of the two input RF-signals (see Fig. 1). If the power ratio of said RF-input signals comes close to 1, the influences of non-ideal characteristics of the RF-subparts get smaller. Therefore, it is advantageous if the range of the (power or magnitude) ratios is brought to 1 as far as possible. According to the present invention there are two solutions proposed:

- To set the level of the LO-oscillator 21 to the average power level coming from the other signal port (RF input signal to be detected), and

- to make online tracking of the LO-circuitry output level to the level of the incoming RF-signal on the other signal port by means of a prediction of the power level of the other incoming signal, e.g. by procedures as shown in the following table 3. Table 3 shows prediction procedures options, wherein RF (t) denotes the RF signal power level in the time sample increment "t".

Table 3

| Procedure Option Number | LO-Circuitry Power level in the next Sample Increment: LO(t+ 1) |
|---|---|
| 1 | RF(t) |
| 2 | 2 RF(t) - RF(t-1) |
| 3 | RF(t) - 3 RF(t-1) + 3 RF(t-2) |

It is to be noted that the procedure options can be further extended using polynomial extrapolations, but in that case an additional computation effort would be required.

The advantage of the proposed 6-port junction topology is that the information of the RF-signal power and the LO circuitry power is available online without computational effort, which makes a real time tracking of the power level possible.

To summarize, the power control function of the local oscillator circuitry 20 can be performed by

- setting the LO-circuitry signal level such as to meet the expected power level of the other signal in the coming time sample by using procedure options as described in table 3, wherein the simple solution of the procedure described in table 3 features to set the LO-circuitry signal level for the time increment (n+ 1) as the same as the RF-signal input level in the time increment (n), or

- setting the LO-circuitry signal power level to the average RF-signal power level, wherein the averaging process can be done online.

The 6-port junction device according to the present invention is particularly adopted to the usage as a direct 6-port receiver. It can be applied as a solution for wide-band applications. If a discrete solution technique is utilized, a wide-band solution is possible also for lower frequency ranges under 10 GHz. According to the present invention the required surface both according to the discrete and the distributed solution is minimized, and furthermore it can be realized by a simple resistor topology.

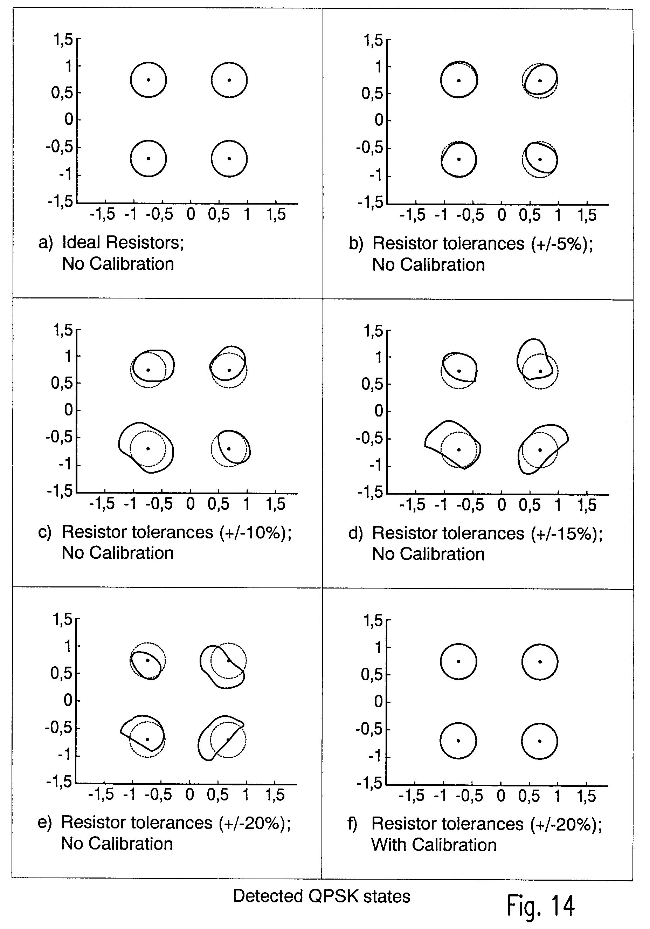

In the following simulation results will be explained with reference to Fig. 14 to 19.

Thereby, the resistive elements discrete topology solution as described in Fig. 7 has been analyzed taking into account the case 2-values for resistors as shown in table one. The simulation environment considered that the resistors can be manufactured with uniformly distributed tolerance approach, meaning that the values of the resistors can vary from 0% to maximally 20%. The phase shifting element with an electrical length of 45 degrees has been taken into account. All of the simulation results are obtained by mathematical simulations taking into account the following items.

-    The power sensors are detector diodes working in a linear region, having input impedance with the same tolerances as a discrete resistor of the assembly,

-    the RF-input signal 2 of Fig. 1 is considered as a local oscillator signal,

-    the circles shown represent margins of the maximum (not of the average) noise,

-    the applied 6-port direct receiver acts as an I/Q-demodulator,

-    the ideal calibration procedure based on 5 loads approach a 6-port to 4-port reduction theory has been utilized where the 5 loads all have the same magnitude, and

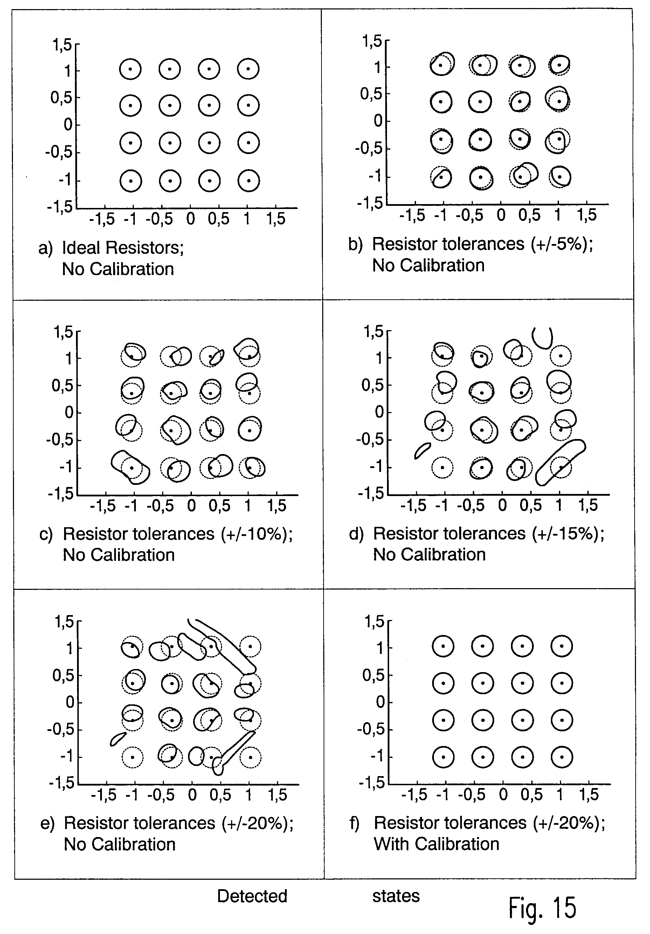

-    in Fig. 15, Fig. 17, and Fig. 19 all respective tolerance imperfections (for each of the percentages) are exactly the same for different demodulation schemes, showing the performance of the same, imperfect 6-port I/Q-demodulator for different modulation schemes.

The signals assumed in the simulations are QPSK, 16 QAM and OFDM modulated signals.

In Fig. 14 simulation results for the QPSK demodulation are shown. One can see that the limit of the S/N ratio equals 10 dB. Due to the randomly obtained resistor tolerances with maximum border from 5% to 20%, different cases as shown in Fig. 12A to Fig. 12F are obtained. The LO-oscillator is considered to have the same power level as the incoming RF-signal to be detected.

It can be seen that the resistor tolerances and the power sensor tolerances of about 5% in the case of an S/N of 10 dB lead to an acceptable error distribution such that there is no need for a calibration procedure. For larger allowed tolerances these issues are more critical. It can be seen that a calibration of the 6-port leads to a full compensation of the resistor tolerances.

With reference to Fig. 15 the case of a QAM-modulated signal is shown. The simulation results of the detected 16 QAM states are shown when detected by the proposed new resistive topology for different values of the resistor tolerances. Thereby the power level of the RF-signal is assumed to be the same power level as the LO-oscillator signal. One can see that the border of the S/N ratio equals 15 dB. Due to the randomly obtained resistor tolerances with a maximum border from 5% to 20% in different cases can be detected. The LO-oscillator is considered to have the same power level as the incoming RF-signal to be detected.

Furthermore it can be seen that the resistor tolerances and power sensor tolerances of about 5% in the case of a S/N of 15 dB leads to acceptable error distributions, such that there is no need to apply a calibration procedure. These issues are more critical for larger allowed tolerances. Furthermore it can be seen that the calibration of the 6-port leads to a full compensation of the resistor tolerances.

It is to be noted that the error propagation is maximum for the states which have the same phase difference as the applied electrical phase shift (in the present case 45 degrees). This fact is to be considered when dimensioning a 6-port receiver design according to the present invention.

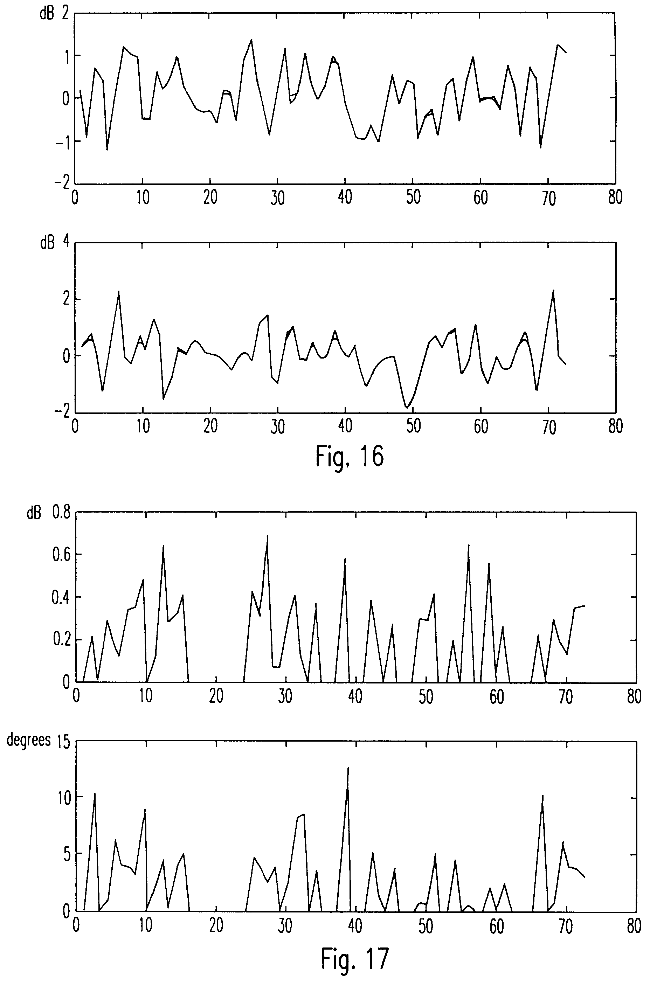

With reference to Fig. 16 to 19 now the simulation results for the case of an OFDM-demodulation will be explained. Thereby, QPSK-OFDM-modulated signals with 64 carriers and 8 carrier guard times are analyzed in the case of the ideal synchronization, ideal LLA amplification and ideal filtering. The simulation results are presented for two cases: with the resistance tolerances of 5% and 20%.

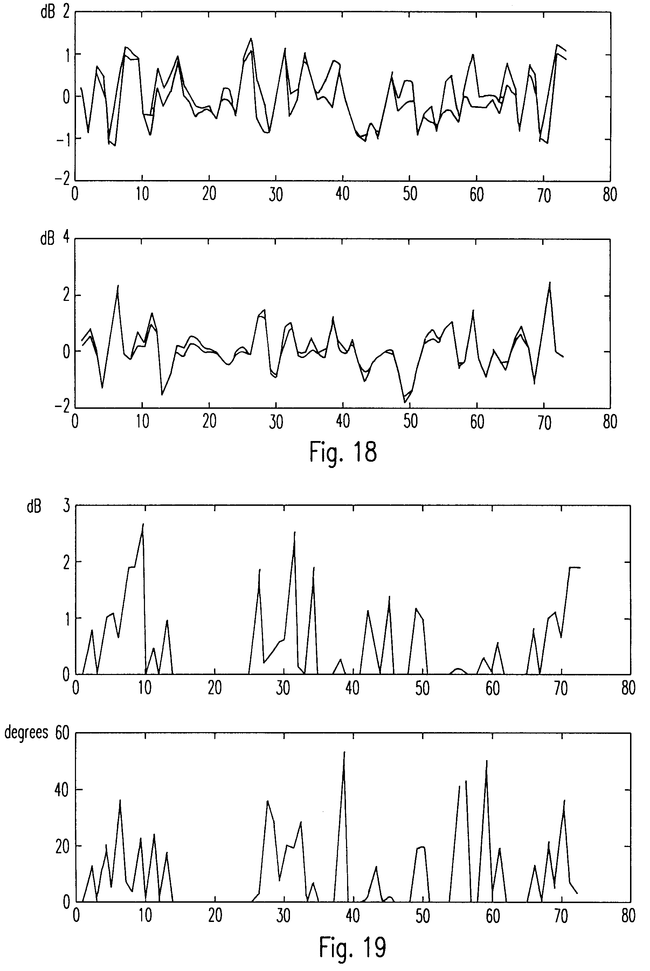

Fig. 16 and 18 show the imaginary and real part, respectively of the typical OFDM-symbol detected in the ideal case (with ideal resistors with calibration) shown by a narrow line and with resistor tolerance as shown by the thicker line.

In Fig. 17 and 19 the following is presented:

a) The relative magnitude mismatch in dB between the ideal values to be detected and the non-ideal values due to the tolerances and

b) the relative phase mismatch in degrees between the ideal values to be detected and the non-ideal values due to the tolerances.

As an additional performance test randomly generated OFDM symbols have been transmitted and demodulated after in I/Q demodulation by the 6-port receiver according to the present invention. The results are shown in the following table 4.

Table 4

| Tolerances | Number of Sent Bits | Number of Detected Errors | BER |
|---|---|---|---|
| ± 5% tolerances; No Noise | 4600 | 0 | 0 |
| ± 5% tolerances; 15 dB S/N | 4600 | 0 | 0 |
| ± 20% tolerances; No Noise | 4600 | 127 | 2.76E-2 |
| ± 20% tolerances 15 dB S/N | 4600 | 171 | 3.72E-2 |

According to these values the necessity to have a calibration for the case that the tolerances are present can be seen. Due to the low number of bits it is statistically not possible to give a definitive answer if there is no error for ± 5% resistance tolerance. In all of the cases a random 15 dB S/N ratio has been considered.

**Claims**

1. Six-port junction device for the processing of RF signals,

   the device comprising two passive four port means (1, 2) being connected with each other by a phase shifting element (3),
   each passive four port means (1, 2) comprising a port (4) for the input of respectively one RF signal and two output ports for providing output signals being linear combinations of the RF input signals,
   wherein power sensors ($P_1$, $P_2$; $P_3$, $P_4$) are provided to detect the respective power levels of the output signals.

2. Six-port device according to claim 1,
   characterized in that

   the two passive four port means (1, 2) are identical and connected symmetrically with each other.

3. Six-port receiver according to claim 1 or 2,
   characterized in that

   respectively a power sensor ($P_1$, $P_2$; $P_3$, $P_4$) is connected to one of said output ports and a signal processing unit (26) is provided to calculate the complex ratio of the two input RF signals on the basis of the power level values detected and output by the power sensors ($P_1$, $P_2$; $P_3$, $P_4$).

4. Six-port junction device according to claim 3,
   characterized in that

   the power sensors ($P_1$, $P_2$; $P_3$, $P_4$) comprise respectively at least one detector diode (13).

5. Six-port junction device according to claim 3 or 4,
   characterized in that

   the power sensors ($P_1$, $P_2$; $P_3$, $P_4$) comprise

   - a matching circuitry (14) realized by discrete or distributed elements,
   - a diode memory block (16) storing diode calibration coefficients,
   - a biasing means (15) and/or

- a processing unit (16) for correcting temperature and nonlinear detection errors.

6. Six-port junction device according to anyone of the preceding claims,
characterized in that

the passive four port means (1, 2) respectively comprise a resistive network (5, 6).

7. Six-port junction device according to anyone of the preceding claims,
characterized in that

the passive four port means (1, 2) respectively three resistive elements (R1, R2, R3) connected in a triangular form.

8. Six-port junction device according to claim 6 or 7,
characterized in that

the passive four port means (1, 2) comprise microstrip rings (27).

9. Six-port junction device according to claim 6 or 7,
characterized in that

the passive four port means (1, 2) comprise circular microstrip patches (28).

10. Six-port junction device according to anyone of the preceding claims,
characterized in that

the phase shifting element (3) is implemented by a plurality of transmission lines (17).

11. Six-port junction device according to claim 9,
characterized in that

the transmission line is a microstrip line (17).

12. Six-port junction device according to anyone of claims 1 to 9,
characterized in that

the phase shifting element comprises a plurality of coplanar strips (18).

13. Six-port junction device according to anyone of claims 1 to 9,
characterized in that

the phase shifting element comprises a coplanar waveguide (19).

14. Six-port junction device according to anyone of the preceding claims,
characterized in that

the phase shifting element (3) comprises at least one LC circuit (10).

15. Six-port junction device according to anyone of the preceding claims,
characterized in that

the phase shifting element (3) comprises a PI circuitry (11).

16. Six-port junction device according to anyone of claims 1 to 13,
characterized in that

the phase shifting element (3) comprises a T-LC circuitry (12).

17. Six-port junction device according to anyone of the preceding claims,
characterized in that

the passive four port means (1, 2) comprises

- a passive power divider (7), and
- a passive three port means (8),

the passive power divider (7) being connected with said input port (4) for a RF signal, with a power sensor ($P_1$, $P_2$; $P_3$, $P_4$) and with the passive three port means (8),
the passive three port means (8) furthermore being connected with another power sensor ($P_1$, $P_2$; $P_3$, $P_4$) and with respectively the other four port means (1, 2) by means of said phase shifting element (3).

18. Six-port junction device according to claim 17,
characterized in that

the passive power divider (7) comprises at least three resistive elements.

19. Six-port junction device according to anyone of claims 17 or 18,
characterized in that

the power divider (7) is realized by a distributed technology.

20. Six-port junction device according to claim 19,
characterized in that

the power divider (7) is realized by a microstrip ring (29) or a circular microstrip patch (30).

21. Six-port junction device according to anyone of claims 17 to 20,
characterized in that

the passive three port means (8, 9) is realized by a distributed technology with a plurality of transmission lines.

22. Six-port junction device according to anyone of claims 17 to 21,
characterized in that

the passive three port means (8, 9) comprises at least two resistive elements.

23. Six-port junction device according to claim 21,
characterized in that

the passive three port means (8, 9) comprises a microstrip line, coplanar strips or a coplanar waveguide.

24. Six-port junction device according to anyone of the preceding claims,
characterized in that

it comprises at least six resistive elements.

25. Six-port junction device according to anyone of the preceding claims,
characterized in that

one of the input RF signals is provided by a local oscillator circuitry (20).

26. Six-port junction device according to claim 25,
characterized in that

the local oscillator circuitry (20) comprises a power control device (23).

**27.** Six-port junction device according to anyone of the preceding claims,
characterized in that

it is realized by MMIC (Monolithic Microwave Integrated Circuit)-Technology.

**28.** Six-port junction device according to anyone of the preceding claims,
characterized in that

it is realized by hybrid technology.

**29.** Use of a six-port junction device according to anyone of the preceding claims for the direct down conversion of a RF signal.

**30.** Use of a six-port junction device according to anyone of claims 1 to 26 for the direct down conversion of a (n)PSK-, (n)QAM- or OFDM-modulated RF signal.

**31.** Method for the direct down conversion of RF signals, comprising the following steps:

- inputting respectively one RF signal to one of two passive four port means (1, 2) being connected with each other by a phase shifting element (3),
- outputting respectively two signals of each of the passive four port means (1, 2), said output signals being based on linear combinations of said two RF input signals, and
- detecting ($P_1$, $P_2$; $P_3$, $P_4$) the power levels of the four output signals.

**32.** Method according to claim 31,
characterized by

the step of providing one of the input RF signals by a local oscillator circuitry (20).

**33.** Method according to claim 32,
characterized in that

the local oscillator circuitry (20) provides for a power control function (23).

**34.** Method according to claim 33,
characterized by the following step:

- setting the power level of the signal provided by the local oscillator circuitry (20) in order to meet the expected power level of the respectively other input RF signal in the following time sample.

**35.** Method according to claim 33,
characterized by the step of

setting the power level of the signal provided by the local oscillator circuitry (20) of the time sample (n + 1) on the power level value of the respectively other RF input signal in the time sample n.

**36.** Method according to claim 33,
characterized by the step of

setting the power level of the signal provided by the local oscillator circuitry (20) on the average power level of the other RF input signal, wherein the averaging step (23) is effected on-line.

**37.** Method for the direct down conversion of RF signals,
comprising the following steps:

- inputting two RF signals to a six-port receiver,
- outputting four output signals being based on linear combinations of said two RF input signals, and
- detecting ($P_1$, $P_2$; $P_3$, $P_4$) the power levels of the four output signals,

wherein one of the input RF signals is provided by a local oscillator circuitry (20) characterized in that

the local oscillator circuitry (20) provides for a power control function (23) for the RF signal output from the local oscillator circuitry (20).

**38.** Method according to claim 37,
characterized by the following step:

- setting the power level of the signal provided by the local oscillator circuitry (20) in order to meet the expected power level of the respectively other input RF signal in the following time sample.

**39.** Method according to claim 37,
characterized by the step of

setting the power level of the signal provided by the local oscillator circuitry (20) of the time sample (n + 1) on the power level value of the respectively other RF input signal in the time sample n.

**40.** Method according to claim 37,
characterized by the step of

setting the power level of the signal provided by the local oscillator circuitry (20) on the average power level of the other RF input signal, wherein the averaging step (23) is effected on-line.

# Fig. 1

RF-Signal 1 → Passive Four Port Structure (1) ↔ Phase Shifter (3) ↔ Passive Four Port Structure (2) ← RF-Signal 2

P₁, P₂, P₃, P₄ → DSP (26)

# Fig. 2

RF-Signal 1 → Resistive Network (5) ↔ Phase Shifter (3) ↔ Resistive Network (6) ← RF-Signal 2 ← LO (20)

P₁, P₂, P₃, P₄ → DSP (26)

# Fig. 3

# Fig. 4

Fig. 5

Fig. 6

Fig. 7

Fig. 8

Fig. 9

Fig. 10

$P_X$

Optional
Biasing ⌐15

14

RF Input →

Optional
matching
network 14

Detector
Diode ⌐13

→ Output
Voltage

Optional
compensation
hardware ⌐16

**Fig. 11**

| Microstrip Line 17 | Complanar Strips 18 | Complanar Waveguide 19 |
|---|---|---|
| +(upper strip) −(lower strip) | + − | − + − |

a)                    b)          **Fig. 12**          c)

Optional
Block with
Isolator
Functionality __22__

Local
Oscillator __21__

Optional
Power
Controling
Hardware __23__

20

Optional PLL
Circuitry __24__

Frequency
Controlling __25__

LO−Circuitry

**Fig. 13**

a) Ideal Resistors;
No Calibration

b) Resistor tolerances (+/-5%);
No Calibration

c) Resistor tolerances (+/-10%);
No Calibration

d) Resistor tolerances (+/-15%);
No Calibration

e) Resistor tolerances (+/-20%);
No Calibration

f) Resistor tolerances (+/-20%);
With Calibration

Detected QPSK states

Fig. 14

a) Ideal Resistors;
No Calibration

b) Resistor tolerances (+/-5%);
No Calibration

c) Resistor tolerances (+/-10%);
No Calibration

d) Resistor tolerances (+/-15%);
No Calibration

e) Resistor tolerances (+/-20%);
No Calibration

f) Resistor tolerances (+/-20%);
With Calibration

Detected        states        Fig. 15

Fig. 16

Fig. 17

Fig. 18

Fig. 19

**European Patent Office**

**EUROPEAN SEARCH REPORT**

Application Number

EP 97 12 2438

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A,D | LI J ET AL: "A SIX-PORT DIRECT DIGITAL MILLIMETER WAVE RECEIVER" IEEE MTT-S INTERNATIONAL MICROWAVE SYMPOSIUM DIGEST, SAN DIEGO, MAY 23 - 27, 1994, vol. VOL. 3, 23 May 1994, KUNO H J;WEN C P (EDITORS), pages 1659-1662, XP000512814 * page 1659, column 1, line 13 - page 161, column 1, line 10; figure 1 * --- | 1,31 | H03D9/04 H04L27/38 |
| A | JI LI ET AL: "A NEW DIRECT DIGITAL RECEIVER PERFORMING COHERENT PSK RECEPTION" IEEE MTT-S INTERNATIONAL MICROWAVE SYMPOSIUM DIGEST, ORLANDO, MAY 16 - 20, 1995, vol. VOL. 3, 16 May 1995, KIRBY L (ED ), pages 1007-1010, XP000552909 * page 1007, column 1, line 1 - page 1009, column 2, line 2; figure 1 * --- | 1,31 | |
| A | EP 0 805 561 A (NOKIA MOBILE PHONES LTD) 5 November 1997 * abstract; figures 1,2 * --- | 1,31 | TECHNICAL FIELDS SEARCHED (Int.Cl.6) H03D H04L G01R |
| A | US 3 956 706 A (SAUL DAVID L) 11 May 1976 * column 2, line 45 - column 3, line 6; figure 2 * --- | 1,31 | |
| A,D | US 4 521 728 A (LI SHIHE) 4 June 1985 ----- | | |

The present search report has been drawn up for all claims

| Place of search | Date of completion of the search | Examiner |
|---|---|---|
| THE HAGUE | 20 May 1998 | Dhondt, I |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)